# EUROPEAN PATENT APPLICATION

(11) **EP 4 239 025 A1**
(43) Date of publication of application: **06.09.2023**
(21) Application number: 21886107.8
(22) Date of filing: 25.10.2021
(51) Int. Cl.: C08L 33/06, C08F 220/06, C08K 5/04, C09J 11/06, C09J 133/02, C09J 133/06

(54) **BASE-RELEASING COMPOSITION AND CURABLE RESIN COMPOSITION USING SAME**

(30) Priority: 29.10.2020 JP 2020181351
(71) Applicant: Namics Corporation, Niigata-shi, Niigata 950-3131 (JP)
(72) Inventor: SATO Ayako, Niigata-shi, Niigata 950-3131 (JP)
(74) Representative: Hoffmann Eitle
(86) International application number: PCT/JP2021/039203
(87) International publication number: WO 2022/091989

(57) **Abstract**

An object of the present invention is to provide a base-releasing composition which suppresses release of a basic compound at room temperature and rapidly releases the basic compound under predetermined conditions, and a curable resin composition using the same.

The base-releasing composition of the present invention comprises (A) a specific side-chain crystalline (meth)acrylate copolymer and (B) a basic compound, wherein the amount of basic groups in the (B) basic compound is within a specific range and at least a portion of the Component (B) is included in the Component (A). The curable resin composition of the present invention comprises a specific 2-methylene-1,3-dicarbonyl compound in combination with the base-releasing composition described above.

## Description

### TECHNICAL FIELD

The present invention relates to a base-releasing composition comprising a specific side-chain crystalline (meth)acrylate copolymer in combination with a basic compound, and a curable resin composition using the same.

### BACKGROUND ART

Currently, adhesives, sealing materials and others comprising curable resin compositions are often used in the assembly and mounting of electronic components used in semiconductor devices for such purposes as maintaining reliability. Such adhesives and sealing materials are required to show sufficient curability even under low temperature conditions of 100 °C or lower. At the same time, they also need to be capable of curing in a short period of time in view of production costs.

In recent years, in the production of electronic components, it has been investigated to use, as an adhesive or the like, a curable resin composition comprising a 2-methylene-1,3-dicarbonyl compound, such as a methylene malonate. A curable resin composition comprising a 2-methylene-1,3-dicarbonyl compound cures in a short time even at a low temperature, such as room temperature, and is useful for avoiding adverse effects due to heating and improving production efficiency. Among these, a one-part curable resin composition is particularly useful for improving production efficiency.

In a one-part curable resin composition, a latent initiator must be used for improving its preservability.

### PRIOR ART DOCUMENTS

### Patent Documents

Patent Document 1: WO 2013/149165
Patent Document 2: WO 96/27641

### SUMMARY OF THE INVENTION

### Problems to be Solved by the Invention

Patent Document 1 discloses a basic compound encapsulated in a wax as a latent initiator for a one-part curable resin composition comprising a 2-methylene-1,3-dicarbonyl compound. This latent initiator rapidly releases the basic compound under predetermined conditions. However, this initiator has a problem in that release of the basic compound is not satisfactorily suppressed at room temperature.

Patent Document 2 discloses an aliphatic or aromatic amine covalently bonded to a side-chain crystalline acrylate copolymer as an initiator for a one-part curable resin composition. This initiator is used for a curable resin composition comprising an epoxy resin. However, use of this initiator in a curable resin composition comprising a 2-methylene-1,3-dicarbonyl compound disadvantageously brings short pot life, due to excess content of basic groups.

As described above, conventionally known latent initiators cannot simultaneously achieve suppression of release of a basic compound at room temperature and rapid release of the basic compound under predetermined conditions.

An object of the present invention is to provide a base-releasing composition which suppresses release of a basic compound at room temperature and rapidly releases the basic compound under predetermined conditions, and a curable resin composition using the same, in order to solve the problems of the prior art described above.

### Solution to the Problems

As a result of intensive research to solve the above-mentioned problems, the present inventors have arrived at the present invention.

That is, the present invention includes, but is not limited to, the following inventions.
1. A base-releasing composition comprising the following Components (A) and (B):
   (A) a side-chain crystalline (meth)acrylate copolymer comprising (i) repeating units each derived from an ester of a C₈-C₃₂ saturated, linear primary alcohol with acrylic acid or methacrylic acid and (ii) repeating units each derived from acrylic acid or methacrylic acid; and
   (B) a basic compound,
      wherein the amount of basic groups in the Component (B) is 0.01 to 1.00 mmol per 1 g of the base-releasing composition, and
      wherein at least a portion of the Component (B) is included in the Component (A).
2. The base-releasing composition according to item 1 above, wherein the molar ratio of basic groups in the Component (B) relative to the repeating units (ii) in the Component (A) is 0.05 to 2.0.
3. The base-releasing composition according to item 1 or 2 above, wherein the Component (B) comprises a basic compound having a linear hydrocarbon group with 8 or more carbon atoms.
4. The base-releasing composition according to any one of items 1 to 3 above, wherein, when the base-releasing composition is heated to a temperature of 50 °C or higher in a medium, the Component (B) is released into the medium.
5. A curable resin composition comprising the base-releasing composition according to any one of items 1 to 4 above and a 2-methylene-1,3-dicarbonyl compound,
   wherein the 2-methylene-1,3-dicarbonyl compound has at least one structural unit represented by formula (I) below. 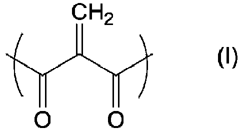
6. A one-part adhesive comprising the curable resin composition of item 5 above.
7. The one-part adhesive according to item 6 above, for electronic components.
8. A cured product which can be obtained by curing the one-part adhesive of item 6 or 7 above.
9. A semiconductor device comprising the cured product of item 8 above.

### Effect of the Invention

The base-releasing composition of the present invention comprises a basic compound in combination with a specific side-chain crystalline (meth)acrylate copolymer. Release of this basic compound from the base-releasing composition of the present invention is suppressed at room temperature but rapidly proceeds under predetermined conditions. Therefore, the curable resin composition of the present invention obtained by mixing this composition with a curable resin, such as a 2-methylene-1,3-dicarbonyl compound, is extremely useful, since the curable resin composition can be stored for a long time at room temperature and, under predetermined conditions, rapidly cures by the action of the released basic compound as an initiator.

### Brief Description of Drawings

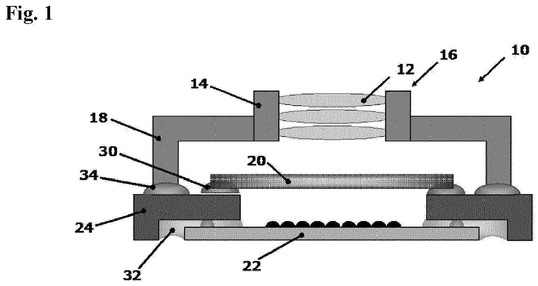

Fig. 1 is a cross-sectional view of a camera module.

### Description of Embodiments

Embodiments of the prevent invention are described below in detail.

The base-releasing composition of the present invention comprises the following Components (A) and (B):
(A) a side-chain crystalline (meth)acrylate copolymer comprising (i) repeating units each derived from an ester of a C₈-C₃₂ saturated, linear primary alcohol with acrylic acid or methacrylic acid and (ii) repeating units each derived from acrylic acid or methacrylic acid; and
(B) a basic compound.

The amount of basic groups in Component (B) is 0.01 to 1.00 mmol per 1 g of the base-releasing composition, and at least a portion of Component (B) is included in Component (A).

Component (A) and Component (B) are described below.

### [Side-chain crystalline (meth)acrylate copolymer (Component (A))]

The base-releasing composition of the present invention comprises a side-chain crystalline (meth)acrylate copolymer (Component (A)). Component (A) comprises the following repeating units (i) and (ii).
(i) Repeating units each derived from an ester of a C₈-C₃₂ saturated, linear primary alcohol with acrylic acid or methacrylic acid
(ii) Repeating units each derived from acrylic acid or methacrylic acid

The side-chain crystalline (meth)acrylate copolymers may be used individually or in combination. Component (A) may comprise repeating units other than repeating units (i) and (ii), the repeating units each derived from a radically polymerizable monomer other than that described above (such as a (meth)acrylate monomer other than that described above), as long as the property side-chain crystallinity is not lost.

The expression a polymer is "side-chain crystalline" herein has an ordinary meaning for a person skilled in the art and means that the polymer exhibits crystallinity derived from the side chain thereof.

By the use of this Component (A), release of the basic compound (Component (B)) from the base-releasing composition of the present invention at room temperature is suppressed. As a result, the curable resin composition obtained by mixing the base-releasing composition of the present invention with a curable resin (for example, a 2-methylene-1,3-dicarbonyl compound) exhibits satisfactorily long pot life at room temperature. It is presumed that in the base-releasing composition of the present invention, at least a portion of Component (B) is incorporated into a crystalline moiety of Component (A) in a solid state, and this potentially causes suppression of release.

On the other hand, Component (A) rapidly melts when it is heated to a predetermined temperature. Therefore, when the base-releasing composition of the present invention is heated to a predetermined temperature, it rapidly releases the basic compound (Component (B)). As a result, the curable resin composition obtained by mixing the base-releasing composition of the present invention with a curable resin rapidly cures when it is heated to a predetermined temperature. The above-mentioned temperature of melting is preferably 35 to 65 °C, more preferably 40 to 60 °C, still more preferably 45 to 58 °C.

Component (A) has side chains each formed by a linear alkyl group (derived from the above-mentioned saturated, linear primary alcohol) in repeating unit (i). The number of carbon atoms of this linear alkyl group is 8 to 32, and this imparts, to the side chains, appropriate crystallinity at room temperature. The ratio of repeating units (i) in Component (A) is preferably in the range of 0.3 to 0.98.

When the number of carbon atoms of this linear alkyl group is 7 or less, release of Component (B) from the base-releasing composition at room temperature is not satisfactorily suppressed. On the other hand, when the number of carbon atoms of this linear alkyl group is more than 32, the temperature necessary for release of Component (B) (curing of the curable resin composition) is too high.

The number of carbon atoms of this linear alkyl group is preferably 12 to 28, more preferably 16 to 26, especially preferably 18 to 22.

The molar ratio between repeating units (i) and repeating units (ii) in Component (A) (repeating unit (i) : repeating unit (ii)) is preferably 98:2 to 65:35, more preferably 95:5 to 65:35, still more preferably 92:8 to 70:30, especially preferably 90:10 to 80:20.

When the content of repeating units (ii) in Component (A) is too high, the curability upon heating for the curable resin composition obtained by mixing the base-releasing composition of the present invention with a curable resin may become unsatisfactory. This may be caused by the presence of excess acidic groups (i.e., carboxyl groups in repeating units (ii)) in the curable resin composition brought by increase in the content of repeating units (ii), which results in suppression of the action of Component (B) as an initiator.

On the other hand, when the content of repeating units (ii) in Component (A) is too low, the pot life of the curable resin composition may become short.

In an embodiment of the present invention, Component (A) is a side-chain crystalline (meth)acrylate copolymer consisting substantially of the above-mentioned repeating units (i) and (ii).

In another embodiment of the present invention, Component (A) is a side-chain crystalline (meth)acrylate copolymer consisting substantially of only the above-mentioned repeating units (i) and (ii). However, in these cases, as apparent to a person skilled in the art, in each molecule of the side-chain crystalline (meth)acrylate copolymer, the structure of the terminal portion may be different from that of other portions.

There is no particular limitation with respect to the arrangement of repeating units (i) and (ii) in Component (A). Therefore, Component (A) may be a copolymer having any arrangement, such as a random copolymer, a block copolymer, an alternating copolymer or the like, and may have a branched structure.

There is no particular limitation with respect to the molecular weight of Component (A). In an embodiment of the present invention, the weight-average molecular weight of Component (A) is preferably 5,000 to 200,000, more preferably 7,000 to 100,000, especially preferably 15,000 to 50,000. The weight-average molecular weight of Component (A) can be determined by gel-permeation chromatography.

Component (A) can be easily prepared by a method known to a person skilled in the art. For example, Component (A) can be prepared by subjecting the following (I) and (II) to a polymerization reaction, such as a radical polymerization reaction.
(I) An ester of a C₈-C₃₂ saturated, linear primary alcohol with acrylic acid or methacrylic acid (precursor of repeating unit (i))
(II) Acrylic acid or methacrylic acid (precursor of repeating unit (ii))

### [Basic compound (Component (B))]

The base-releasing composition of the present invention comprises a basic compound (Component (B)).

There is no particular limitation with respect to the basic compound which can be used as Component (B) in the present invention as long as the compound can be included in Component (A). The basic compound may be, for example, an aliphatic basic organic compound, such as a trialkylamine, or an aromatic basic organic compound having a nirtogen-containing aromatic ring (such as an imidazole ring, a pyridine ring and the like). As examples of basic compounds which can be used in the present invention, there can be mentioned:
trialkylamines, such as dimethyloctylamine, methylethyloctylamine, dimethyldecylamine, methylethyldecylamine, dimethylundecylamine, methylethylundecylamine, dimethyldodecylamine, methylethyldodecylamine, dimethyltetradecylamine, methylethyltetradecylamine, dimethylhexadecylamine, methylethylhexadecylamine, dimethylheptadecylamine, methylethylheptadecylamine, dimethyloctadecylamine, methylethyloctadecylamine, dimethylicosylamine, methylethylicosylamine, dimethylbehenylamine, methylethylbehenylamine and the like;
1-monoalkylimidazoles, such as 1-methylimidazole, 1-octylimidazole, 1-decylimidazole, 1-undecylimidazole, 1-dodecylimidazole, 1-tetradecylimidazole, 1-hexadecylimidazole, 1-heptadecylimidazole, 1-octadecylimidazole, 1-icosylimidazole, 1-behenylimidazole and the like;
2-monoalkylimidazoles, such as 2-methylimidazole, 2-octylimidazole, 2-decylimidazole, 2-undecylimidazole, 2-dodecylimidazole, 2-tetradecylimidazole, 2-hexadecylimidazole, 2-heptadecylimidazole, 2-octadecylimidazole, 2-icosylimidazole, 2-behenylimidazole and the like;
2-alkylpyridines, such as 2-methylpyridine (α-picoline), 2-octylpyridine, 2-decylpyridine, 2-undecylpyridine, 2-dodecylpyridine, 2-tetradecylpyridine, 2-hexadecylpyridine, 2-heptadecylpyridine, 2-octadecylpyridine, 2-icosylpyridine, 2-behenylpyridine and the like;
3-alkylpyridines, such as 3-methylpyridine (β-picoline), 3-octylpyridine, 3-decylpyridine, 3-undecylpyridine, 3-dodecylpyridine, 3-tetradecylpyridine, 3-hexadecylpyridine, 3-heptadecylpyridine, 3-octadecylpyridine, 3-icosylpyridine, 3-behenylpyridine and the like; and
4-alkylpyridines, such as 4-methylpyridine (γ-picoline), 4-octylpyridine, 4-decylpyridine, 4-undecylpyridine, 4-dodecylpyridine, 4-tetradecylpyridine, 4-hexadecylpyridine, 4-heptadecylpyridine, 4-octadecylpyridine, 4-icosylpyridine, 4-behenylpyridine and the like.

The basic compounds as Components (B) may be used individually or in combination.

The amount of basic groups in Component (B) is 0.01 to 1.00 mmol per 1 g of the base-releasing composition of the present invention. When the amount of basic groups in Component (B) is less than 0.01 mmol per 1 g of the base-releasing composition, the amount of Component (B) released upon heating from the base-releasing composition is unsatisfactory, and the curability upon heating for the curable resin composition obtained by mixing the base-releasing composition with a curable resin may become unsatisfactory. When the amount of the base-releasing composition in the curable resin composition is increased, the curability is improved. However, this increases components which do not contribute to curing reaction. Therefore, the cured product obtained by curing the curable resin composition may exhibit unintended property, for example, the cured product may become brittle. On the other hand, when the amount of basic groups in Component (B) is more than 1.00 mmol per 1 g of the base-releasing composition, the pot life of the curable resin composition may become short.

In the present invention, the amount of basic groups may be conveniently given in (m)mol, a unit usually used for a compound (molecule) and/or ion. In the present invention, when the amount of basic groups can be calculated from the amounts of blended components, the calculated value is used as the amount. When this calculation is impossible, the amount of basic groups is determined by a method well known to a person skilled in the art, such as NMR, titration, gas chromatography, liquid chromatography, capillary electrophoresis or the like. For example, when 0.01 mmol of ethylenediamine or 2-methylimidazole is contained in 1 g of the base-releasing composition, the amount of basic groups is 0.02 mmol per 1 g of this base-releasing composition.

In the base-releasing composition of the present invention, at least a portion of Component (B) is included in Component (A). In the present invention, the expression Component (B) "is included" in Component (A) means that Component (A) and Component (B) coexist in the base-releasing composition with effective Component (A)-Component (B) interaction and no covalent bond between Component (A) and Component (B), the interaction suppressing release of Component (B) from the base-releasing composition. It is presumed that in the base-releasing composition of the present invention, at least a portion of Component (B) is incorporated into a crystalline moiety of Component (A). In this case, the molecule of the basic compound, which is Component (B), may be entirely incorporated into the crystalline moiety, and a portion of the molecular structure of the compound may be incorporated into the crystalline moiety. Interaction between Component (A) (especially the crystalline moiety thereof) and Component (B) in this state potentially brings suppression of release.

For example, when Component (B) has a linear hydrocarbon group (especially that having a large number of carbon atoms to some extent), interaction between this linear hydrocarbon group and the crystalline moiety of Component (A) (mainly provided by the side chain of Component (A) (linear alkyl group in repeating unit (i))) potentially contributes to suppression of release of Component (B) at room temperature.

Further, in some cases, some of Component (A) and Component (B) are charged due to withdrawal of protons by Component (B) from carboxyl groups of Component (A). In such a case, electrostatic interaction between Component (A) and Component (B) potentially contributes to suppression of release of Component (B) from the base-releasing composition at room temperature. In fact, when carboxyl groups in Component (A) are converted to methoxycarbonyl groups, release of Component (B) at room temperature is not satisfactorily suppressed. In an embodiment of the present invention, when Component (B) is included in Component (A), there is effective ionic interaction between Component (A) and Component (B).

In another embodiment of the present invention, when Component (B) is included in Component (A), there is effective hydrophobic interaction between Component (A) and Component (B).

In a further embodiment of the present invention, when Component (B) is included in Component (A), Component (B) is encapsulated in Component (A) or Component (B) is provided in inactive engagement with a curable resin by chemical inactivation.

In an embodiment of the present invention, at least 50 mol%, preferably at least 70 mol%, more preferably at least 80 mol% of Component (B) in the base-releasing composition is included in Component (A) at room temperature.

From the viewpoint of appropriate interaction between Component (A) and Component (B) to provide satisfactory suppression of release of Component (B) at room temperature, it is preferred that Component (B) has a hydrocarbon group with at least one carbon atom. It is preferred that the hydrocarbon group with at least one carbon atom is a linear hydrocarbon group. It is preferred that Component (B) comprises a basic compound having a linear hydrocarbon group with 8 or more carbon atoms. With respect to this linear hydrocarbon group, the number of carbon atoms is preferably 1 to 24, more preferably 3 to 18, especially preferably 8 to 18. In an embodiment, in Component (B), the ratio of the basic compound having a linear hydrocarbon group with 8 or more carbon atoms is preferably 30 to 100 mol%, more preferably 50 to 100 mol%, still more preferably 70 to 100 mol%.

In the base-releasing composition of the present invention, the molar ratio of basic groups in Component (B) relative to repeating units (ii), i.e., acrylic acid residues or methacrylic acid residues in Component (A), is preferably 0.05 to 2.0, more preferably 0.10 to 1.5, particularly preferably 0.10 to 1.2. When this molar ratio is less than 0.05, the amount of Component (B) released from the base-releasing composition upon heating is unsatisfactory, and the curability upon heating for the curable resin composition obtained by mixing the base-releasing composition with a curable resin may become unsatisfactory. When the amount of the base-releasing composition in the curable resin composition is increased, the curability is improved. However, this increases components which do not contribute to curing reaction. Therefore, the cured product obtained by curing the curable resin composition may exhibit unintended property, for example, the cured product may become brittle. On the other hand, when this molar ratio is more than 2.0, the pot life of the curable resin composition may become short.

The molar ratio of basic groups in Component (B) relative to the repeating units (ii) herein refers to the ratio of the total number of basic groups in Component (B) relative to the total number of repeating units (ii) in Component (A) contained in the base-releasing composition. For example, the "total number of basic groups in Component (B)" refers to the value obtained by multiplying the number of molecules of the (B) basic compound contained in the base-releasing composition by the number of basic groups per 1 molecule of the basic compound.

From the base-releasing composition of the present invention as described above, Component (B) is released under predetermined conditions. The conditions under which Component (B) is released vary depending on the properties of Component (A) and Component (B) or the like. A person skilled in the art can obtain desired conditions by appropriately adjusting, for example, the length of the side chain of Component (A), the interaction between Component (A) and Component (B), and the like. By the action of Component (B) released as described above as an initiator, the curable resin composition obtained by mixing the base-releasing composition of the present invention with a curable resin rapidly cures.

In an embodiment of the present invention, when the base-releasing composition of the present invention is heated to a temperature of 50 °C or higher in a medium, Component (B) is released into the medium. This temperature for heating is more preferably 52 °C or higher, still more preferably 55 °C or higher. The medium is preferably in a liquid form. In an embodiment of the present invention, the medium is a non-aqueous medium. The medium may comprise a 2-methylene-1,3-dicarbonyl compound. In another embodiment of the present invention, the medium is an aqueous medium.

The base-releasing composition of the present invention may comprise, if necessary, in addition to Component (A) and (B) described above, a polymerization inhibitor, an antioxidant, a coloring agent and the like.

The base-releasing composition of the present invention can be prepared by mixing Component (A) and (B) described above and, if necessary, the above-mentioned components, such as a polymerization inhibitor, an antioxidant, a coloring agent and the like. Apparatuses known in the art can be used for mixing. For example, mixing can be performed by apparatuses known in the art, such as a Henschel mixer or a roll mill. These components may be mixed simultaneously, or it may be such that some are mixed first, and the remainder are mixed later.

In an embodiment of the present invention, the base-releasing composition may be processed into a powder by a technique such as spray drying. If necessary, the base-releasing composition may be pulverized with, for example, a bead mill or the like.

A curable resin which is curable with a basic compound can be cured with the base-releasing composition of the present invention. In an embodiment, the curable resin which is curable with a basic compound is a 2-methylene-1,3-dicarbonyl compound. In the present invention, also provided is a base-releasing composition for curing a 2-methylene-1,3-dicarbonyl compound. Further in the present invention, also provided is use of the base-releasing composition of the present invention for curing a 2-methylene-1,3-dicarbonyl compound.

The base-releasing composition of the present invention is useful especially for the production of electronic components.

### [Curable resin composition]

In the present invention, also provided is a curable resin composition comprising the base-releasing composition of the present invention and a 2-methylene-1,3-dicarbonyl compound. The curable resin composition of the present invention exhibits a long pot life at room temperature and, when it is heated to a predetermined temperature, rapidly cures by the effect, as an initiator, of Component (B) released from the base-releasing composition and diffused into the 2-methylene-1,3-dicarbonyl compound. Because of these properties, the curable resin composition of the present invention is extremely useful for the production of electronic components.

Hereinafter, the 2-methylene-1,3-dicarbonyl compound is explained.

### [2-Methylene-1,3-dicarbonyl compound]

In the present invention, the 2-methylene-1,3-dicarbonyl compound is a compound comprising at least one structural unit represented by formula (I) below.

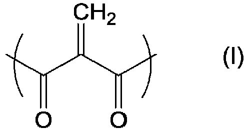

The 2-methylene-1,3-dicarbonyl compound comprises one or two or more of structural units of formula (I) above. In some embodiments, the 2-methylene-1,3-dicarbonyl compound comprises two to six, preferably two, structural units of formula (I) above.

Since the 2-methylene-1,3-dicarbonyl compound comprises a structural unit of formula (I) above, these structural units polymerize with each other in the presence of an initiator, typically a basic substance (for example, the basic compound (Component (B)) released from the base-releasing composition of the present invention). However, in the absence of an initiator, the 2-methylene-1,3-dicarbonyl compound does not polymerize even when it is heated to some extent (for example, to approximately 50 °C). If the 2-methylene-1,3-dicarbonyl compounds comprise 2-methylene-1,3-dicarbonyl compounds that comprise two or more structural units of formula (I) above (multifunctional 2-methylene-1,3-dicarbonyl compounds), cross-links are formed during curing, and this is expected to result in improvement in physical properties of the cured product such as enhanced mechanical properties at high temperatures.

In some embodiments of the present invention, under the conditions that Component (B) in the curable resin composition is included in Component (A), Component (B) is provided in inactive engagement with the 2-methylene-1,3-dicarbonyl compound by chemical inactivation.

The 2-methylene-1,3-dicarbonyl compounds can be used individually or in combination. The 2-methylene-1,3-dicarbonyl compound preferably has a molecular weight of 180 to 10,000, more preferably 180 to 5,000, even more preferably 180 to 2,000, even more preferably 220 to 2,000, even more preferably 200 to 1,500, even more preferably 240 to 1,500, even more preferably 250 to 1,500, particularly preferably 250 to 1,000, and most preferably 260 to 1,000. The molecular weight of the 2-methylene-1,3-dicarbonyl compound, and the amount by weight of the 2-methylene-1,3-dicarbonyl compound contained relative to the entire curable resin composition (or the totality of the 2-methylene-1,3-dicarbonyl compounds in the curable resin composition) of 1, can be determined, for example, by reversed phase high performance liquid chromatography (reversed phase HPLC) using an ODS column as the column and a mass spectrometer (MS) with PDA (detection wavelength: 190 nm to 800 nm), or ELSD, as the detector. If the molecular weight of the 2-methylene-1,3-dicarbonyl compound is less than 180, the vapor pressure at 25 °C may be excessively high, which may cause various problems arising from volatiles. In particular, volatiles will, on adhering to components in their vicinity, be cured by bases on the surface, leading to contamination of the components in their vicinity. By contrast, if the molecular weight of the 2-methylene-1,3-dicarbonyl compound exceeds 10,000, it results in the viscosity of the curable resin composition becoming high, which decreases workability and also causes other issues such as imposing limitations on the amount of fillers that can be added.

The 2-methylene-1,3-dicarbonyl compound may be multifunctional. Multifunctional herein means that the 2-methylene-1,3-dicarbonyl compound comprises two or more structural units of formula (I) above. The number of structural units of formula (I) contained in a 2-methylene-1,3-dicarbonyl compound is referred to as the "number of functional groups" of the 2-methylene-1,3-dicarbonyl compound. Of the 2-methylene-1,3-dicarbonyl compounds, those for which the number of functional groups is one are called "monofunctional"; those for which the number of functional groups is two are called "bifunctional"; and those for which the number of functional groups is three are called "trifunctional." Since a cured product obtained using a multifunctional 2-methylene-1,3-dicarbonyl compound is cross-linked, the cured product has improved physical properties, such as heat resistance and mechanical properties at high temperatures. When a multifunctional 2-methylene-1,3-dicarbonyl compound is used, the ratio by weight of the multifunctional 2-methylene-1,3-dicarbonyl compound is preferably 0.01 or greater, relative to the entire curable resin composition of the present invention of 1. In an embodiment, the ratio by weight of multifunctional 2-methylene-1,3-dicarbonyl compounds that comprise two or more structural units represented by formula (I) above is preferably 0.01 to 1.00, more preferably 0.05 to 0.95, even more preferably 0.05 to 0.90, particularly preferably 0.10 to 0.90, most preferably 0.20 to 0.80, relative to the entire curable resin composition of the present invention of 1.

If a multifunctional 2-methylene-1,3-dicarbonyl compound is used, a network-like cross-linked structure is formed in the cured product, with the result that the cured product does not flow and maintains a constant storage modulus even at high temperatures, in particular, at temperatures equal to or higher than its glass transition temperature. The storage modulus of the cured product at high temperatures can be measured, for example, by dynamic mechanical analysis (DMA). Typically, if a cured product having a cross-linked structure formed therein is measured by DMA, a region known as a plateau is observed over a wide temperature range above its glass transition temperature where changes in storage modulus are relatively small as the temperature changes. The storage modulus in this plateau region is evaluated as a quantity related to crosslink density, i.e., the proportion of the multifunctional 2-methylene-1,3-dicarbonyl compound.

In an embodiment, the ratio by weight of the 2-methylene-1,3-dicarbonyl compound is preferably 0.10 to 0.999, more preferably 0.20 to 0.995, and particularly preferably 0.50 to 0.99, relative to the entire curable resin composition of the present invention of 1.

In an embodiment, the 2-methylene-1,3-dicarbonyl compound is represented by formula (II) below: 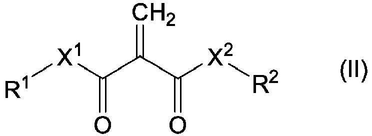 wherein
X¹ and X² each, independently, represent a single bond, O or NR³, wherein R³ represents hydrogen or a monovalent hydrocarbon group; and
R¹ and R² are each, independently, hydrogen, a monovalent hydrocarbon group, or represented by formula (III) below: 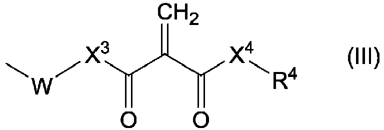 wherein
X³ and X⁴ each, independently, represent a single bond, O or NR⁵, wherein R⁵ represents hydrogen or a monovalent hydrocarbon group;
W represents a spacer; and
R⁴ represents hydrogen or a monovalent hydrocarbon group.

In an embodiment, the 2-methylene-1,3-dicarbonyl compound is represented by formula (IV) below: 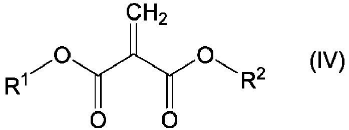
wherein R¹ and R² are each, independently, hydrogen, a monovalent
hydrocarbon group, or represented by formula (V) below: 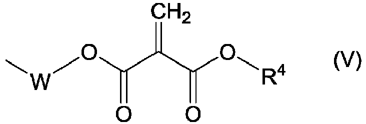 wherein
W represents a spacer; and
R⁴ represents hydrogen or a monovalent hydrocarbon group.

In another embodiment, the 2-methylene-1,3-dicarbonyl compound is a dicarbonylethylene derivative represented by formula (VI) below: 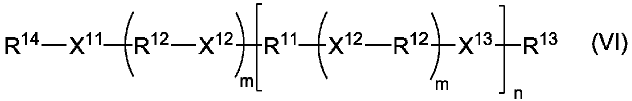 wherein
R¹¹ represents a 1,1-dicarbonylethylene unit represented by formula (VII) below: 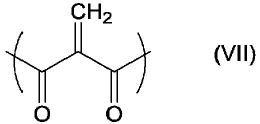
each R¹² each, independently, represents a spacer;
R¹³ and R¹⁴ each, independently, represent hydrogen or a monovalent hydrocarbon group;
X¹¹ and each X¹² and X¹³ each, independently, represent a single bond, O or NR¹⁵, wherein R¹⁵ represents hydrogen or a monovalent hydrocarbon group;
each m each, independently, represents 0 or 1; and
n represents an integer of 1 or greater and 20 or less;

As used herein, a monovalent hydrocarbon group refers to the group that results if one hydrogen atom is removed from a carbon atom in a hydrocarbon. Examples of the monovalent hydrocarbon group include an alkyl group, an alkenyl group, an alkynyl group, a cycloalkyl group, an alkyl-substituted cycloalkyl group, an aryl group, an aralkyl group, and an alkaryl group, and some of these may comprise heteroatoms such as N, O, S, P and Si.

Each of the monovalent hydrocarbon groups above may be substituted with alkyl, cycloalkyl, heterocyclyl, aryl, heteroaryl, allyl, alkoxy, alkylthio, hydroxyl, nitro, amide, azide, cyano, acyloxy, carboxy, sulfoxy, acryloxy, siloxy, epoxy, or ester.

The monovalent hydrocarbon group is preferably an alkyl group, a cycloalkyl group, an aryl group, or an alkyl group substituted with a cycloalkyl group, more preferably, an alkyl group, a cycloalkyl group, or an alkyl group substituted with a cycloalkyl group.

There are no particular restrictions on the carbon number of the alkyl group, alkenyl group, and alkynyl group (hereinafter collectively referred to as the "alkyl group etc."). The carbon number of the alkyl group is typically 1 to 18, preferably 1 to 16, more preferably 2 to 12, even more preferably 3 to 10, particularly preferably 4 to 8. The carbon number of the alkenyl group and the alkynyl group is typically from 2 to 12, preferably from 2 to 10, more preferably from 3 to 8, even more preferably from 3 to 7, and particularly preferably from 3 to 6. If the alkyl group etc. have a cyclic structure, the number of carbon atoms in the alkyl group etc. is typically 5 to 16, preferably 5 to 14, more preferably 6 to 12, even more preferably 6 to 10. The carbon number of the alkyl group etc. can be identified by, for example, reverse phase HPLC, described above, or nuclear magnetic resonance (NMR).

There are no particular restrictions on the structure of the alkyl group etc. The alkyl group etc. may be linear or may have a side chain. The alkyl group etc. may have a chain structure or a cyclic structure (a cycloalkyl group, a cycloalkenyl group, and a cycloalkynyl group). The alkyl group etc. may have one or more other substituents. For example, the alkyl group etc. may have a substituent comprising an atom other than a carbon atom or a hydrogen atom as a substituent. Also, the alkyl group etc. may comprise one or more atoms other than a carbon atom or a hydrogen atom in a chain structure or a cyclic structure. Examples of the atoms other than a carbon atom or a hydrogen atom above include one or more of an oxygen atom, a nitrogen atom, a sulfur atom, a phosphorus atom, and a silicon atom.

Specific examples of the alkyl group include a methyl group, an ethyl group, an n-propyl group, an i-propyl group, an n-butyl group, an i-butyl group, a sec-butyl group, a t-butyl group, a pentyl group, an isopentyl group, a neopentyl group, a hexyl group, a heptyl group, an octyl group, and a 2-ethylhexyl group. Specific examples of the cycloalkyl group include a cyclopentyl group, a cyclohexyl group, a cycloheptyl group, and a 2-methylcyclohexyl group. Examples of the alkenyl group include a vinyl group, an allyl group, and an isopropenyl group. Specific examples of the cycloalkenyl group include a cyclohexenyl group.

When the 2-methylene-1,3-dicarbonyl compound is represented by formula (II) or (IV) above and R¹ and R² are both monovalent hydrocarbon groups, it is particularly preferable that R¹ and R² are, each, an alkyl group, a cycloalkyl group, an alkyl-substituted cycloalkyl group, an aryl group, an aralkyl group, or an alkaryl groups having 2 to 8 carbons.

As used herein, a spacer refers to a divalent hydrocarbon group, more specifically a cyclic, linear or branched, substituted or unsubstituted alkylene group. There are no particular restrictions on the carbon number of the alkylene group. The carbon number of the alkylene group is usually 1 to 12, preferably 2 to 10, more preferably 3 to 8, and still more preferably 4 to 8. If desired, the alkylene group may comprise a group comprising a heteroatom selected from N, O, S, P, and Si. The alkylene group may have an unsaturated bond. In an embodiment, the spacer is an unsubstituted alkylene group having 4 to 8 carbon atoms. Preferably, the spacer is a linear, substituted or unsubstituted alkylene group, more preferably, an alkylene group having a structure represented by the formula -(CH₂)ₙ-, wherein n is an integer from 2 to 10, preferably from 4 to 8, and wherein the carbon atoms at both ends are bonded to the remaining moieties of the 2-methylene-1,3-dicarbonyl compound.

Specific examples of the divalent hydrocarbon group for the spacer include, but are not limited to, a 1,4-n-butylene group and a 1,4-cyclohexylene dimethylene group.

If the 2-methylene-1,3-dicarbonyl compound has a spacer, the number of carbon atoms in the terminal monovalent hydrocarbon group is preferably 6 or less. That is, if the 2-methylene-1,3-dicarbonyl compound is represented by formula (II) or (IV) above, it is preferable that R⁴ in formula (III) or (V) above be alkyl having 1 to 6 carbon atoms, but if either one of R¹ and R² is represented by formula (III) or formula (V) above, it is preferable that the other of R¹ and R² be alkyl having 1 to 6 carbon atoms. In this case, in formula (II) or formula (IV) above, both R¹ and R² may be represented by formula (III) or formula (V) above, and preferably, only either one of R¹ and R² is represented by formula (III) or formula (V) above. Preferably, the 2-methylene-1,3-dicarbonyl compound is represented by formula (IV) above.

Examples of particularly preferable compounds that have a spacer include compounds represented by formula (IV) above, wherein either one of R¹ and R² is any one of an ethyl group, an n-hexyl group or a cyclohexyl group, the other one is represented by formula (V) above, W is either a 1,4-n-butylene group or a 1,4-cyclohexylene dimethylene group, and R⁴ is any one of an ethyl group, an n-hexyl group or a cyclohexyl group. Further, other particularly preferable compounds include compounds represented by formula (IV) above, wherein R¹ and R² are represented by formula (V) above, W is either a 1,4-n-butylene group or a 1,4-cyclohexylene dimethylene group, and R⁴ is any one of an ethyl group, an n-hexyl group or a cyclohexyl group.

A variety of 2-methylene-1,3-dicarbonyl compounds are available from Sirrus Inc., Ohio, USA, and synthetic methods thereof are disclosed in publications of patent applications such as WO2012/054616, WO2012/054633 and WO2016/040261. If both ends of the structural unit represented by formula (I) above contained in the 2-methylene-1,3-dicarbonyl compound are bonded to oxygen atoms, 2-methylene-1,3-dicarbonyl compounds having a higher molecular weight in which a plurality of structural units represented by formula (I) above are linked via an ester bond and the spacer above can be produced by using methods known in the art such as the transesterification with a diol or a polyol disclosed in Japanese Translation of PCT International Application Publication No. JP-T-2015-518503. A 2-methylene-1,3-dicarbonyl compound thus prepared may comprise a hydroxy group in R¹ and R² in formula (II) or formula (IV) above, R⁴ in formula (III) or formula (V) above, and R¹⁴ and R¹³ in formula (VI) above. The 2-methylene-1,3-dicarbonyl compounds can be obtained, as appropriate, by combining these 2-methylene-1,3-dicarbonyl compounds.

Specific examples of suitable 2-methylene-1,3-dicarbonyl compounds include dibutyl methylene malonate, dipentyl methylene malonate, dihexyl methylene malonate, dicyclohexyl methylene malonate, ethyl octyl methylene malonate, propyl hexyl methylene malonate, 2-ethylhexyl-ethyl methylene malonate, ethylphenyl-ethyl methylene malonate and the like. These are preferable because of their low volatility and high reactivity. From the perspective of handleability, dihexyl methylene malonate and dicyclohexyl methylene malonate are particularly preferable.

The curable resin composition of the present invention may comprise, if necessary, in addition to the base-releasing composition and 2-methylene-1,3-dicarbonyl compound described above, a stabilizer, a curing accelerator, an insulating or conductive filler, a surface treatment agent such as a coupling agent, a pigment, a plasticizer, a flame retardant, an ion trapper, an antifoaming agent, a leveling agent, a foam breaker or the like.

The curable resin composition of the present invention comprises the base-releasing composition and 2-methylene-1,3-dicarbonyl compound described above and, if necessary, the above-mentioned component(s) such as the stabilizer. The curable resin composition of the present invention can be prepared by mixing these components. Apparatuses known in the art can be used for mixing. For example, mixing can be performed by apparatuses known in the art, such as a Henschel mixer or a roll mill. These components may be mixed simultaneously, or it may be such that some are mixed first, and the remainder are mixed later. From the viewpoint of prevention of unintended curing, mixing at 40 °C or lower is preferred.

In the present invention, also provided is a one-part adhesive comprising the curable resin composition of the present invention. The one-part adhesive of the present invention exhibits a long pot life at room temperature and rapidly cures when it is heated to a predetermined temperature. Because of these properties, the one-part adhesive of the present invention is suitable particularly for use in electronic components. Specifically, the curable resin composition of the present invention is suitable for the adhesion and sealing of electronic components. More specifically, the curable resin composition of the present invention can be used for the adhesion and sealing of components for camera modules, and is particularly suitable for adhesion of image sensor modules. In the present invention, also provided is an electronic component adhered using the curable resin composition of the present invention. Further, also provided is an electronic component sealed using the curable resin composition of the present invention. In addition, the curable resin composition of the present invention can be used both as an insulating composition and as a conductive composition.

The curable resin composition of the present invention can also be used for an image sensor module other than a camera module. For example, it can be used for adhesion and sealing of components of an image sensor module that may be incorporated in a fingerprint authentication device, a face authentication device, a scanner, a medical device, or the like.

The curable resin composition of the present invention can also be used as a constituent material of a film or a prepreg. In particular, the curable resin composition of the present invention is suitable for a constituent material of a coverlay film for protecting wiring patterns, an interlayer adhesive film for a multilayer wiring substrate, and a prepreg. The film or prepreg comprising the curable resin composition of the present invention, preferably, can be used for electronic components.

The prepreg comprising the curable resin composition of the present invention can be produced by methods known in the art such as, for example, a hot melt method or a solvent method. When a hot melt method is used, a prepreg can be produced, without dissolving the curable resin composition of the present invention in an organic solvent, by first applying a temporary coating of the curable resin composition of the present invention onto a release paper having good releasability against the curable resin composition and then laminating it on a sheet of fiber substrate, or by directly applying a coating using a die coater, or by other methods. When a solvent method is used, a sheet of fiber substrate is first immersed in a curable resin composition varnish prepared by dissolving the curable resin composition of the present invention in an organic solvent, thereby impregnating the curable resin composition varnish into the sheet of fiber substrate, and then the sheet of fiber substrate is dried to obtain a prepreg.

The film comprising the curable resin composition of the present invention can be obtained from the curable resin composition of the present invention by methods known in the art. For example, the curable resin composition of the present invention can be diluted with a solvent to form a varnish, which is applied to at least one side of a support, dried, and then provided as a film with a support or as a film detached from the support.

In the present invention, also provided is a cured product which can be obtained by curing the one-part adhesive of the present invention. The curing is achieved typically by heating of the one-part adhesive, but may be achieved by other methods known to a person skilled in the art.

In the present invention, also provided is a semiconductor device comprising the cured product of the present invention. The semiconductor devices are preferably various kinds of sensor modules.

### EXAMPLES

Examples and Comparative Examples of the present invention will be described below. The present invention is not limited to the following Examples and Comparative Examples. In the following Examples and Comparative Examples, the proportions of the components contained in curable resin compositions are given in parts by weight.

In the explanation below, the following abbreviations may be used.
- PEG-8000:: Polyethylene glycol 8000
- SA:: Stearyl acrylate
- DA:: Docosyl acrylate
- DMAEA:: 2-(Dimethylamino)ethyl acrylate
- C12SH:: 1-Dodecanethiol
- V-601:: Dimethyl 2,2'-Azobis(isobutyrate)
- AA:: Acrylic acid
- MAA:: Methyl acrylate
- MA:: Methacrylic acid
- DMOA:: N,N-Dimethyl-n-octadecylamine
- AIBN:: 2,2'-Azobis(isobutyronitrile)
- IPA:: 2-Propanol
- 2MZ:: 2-Methylimidazole
- C11Z:: 2-Undecylimidazole
- C17Z:: 2-Heptadecylimidazole
- octPy:: 4-Octylpyridine

The molecular weights (in terms of polystyrene) of the copolymers prepared below were determined by gel permeation chromatography (GPC) under the following conditions, as appropriate.

| | |
|---|---|
| Chromatograph: | GL-7480 (manufactured by GL Sciences Inc.) |
| Column: | Shodex GPC KF804L (manufactured by Showa Denko K.K., 2 columns connected in series) |
| Detector: | Differential refractometer |
| Mobile phase: | THF |
| Column temperature: | 40 °C |
| Flow rate: | 1 mL/min. |

### [Preparation of Base-releasing Compositions]

The raw materials for the base-releasing compositions used in the Examples and Comparative Examples below are as follows.

### Side-chain crystalline (meth)acrylate copolymers (Components (A)):

### (A-1) SA-AA copolymer (SA:AA = 95:5 (molar ratio))

SA (another name: octadecyl acrylate, 90-10045, manufactured by FUJIFILM Wako Pure Chemical Corporation, 15.0 g, 46 mmol) and AA (017-00773, manufactured by FUJIFILM Wako Pure Chemical Corporation, 167 mg, 2.32 mmol) were dissolved in IPA (30 mL) and, to the resultant solution, V-601 (043-28532, manufactured by FUJIFILM Wako Pure Chemical Corporation, 55.7 mg, 0.242 mmol) was further added. After degassing by bubbling with argon gas, the resultant solution was reacted at 60 °C for 18 hours. The resultant reaction mixture was cooled to room temperature under stirring, and deposited solids were collected by suction filtration and dried, to thereby obtain 14 g of (A-1).

### (A-2) SA-AA copolymer (SA:AA = 90:10 (molar ratio))

SA (116.8 g, 360 mmol) and AA (2.88 g, 40 mmol) were dissolved in IPA (120 g) and, after degassing by bubbling with nitrogen gas, the resultant solution was heated to 60 °C under stirring. To this solution was added, under nitrogen stream, a solution of AIBN (A0566, manufactured by Tokyo Chemical Industry Co., Ltd., 330 mg, 2.00 mmol) in IPA (20 g). The resultant mixture was heated to 80 °C and reacted at this temperature for 8 hours. The resultant reaction mixture was cooled to room temperature under stirring, and added to 1,500 mL of IPA. Deposited solids were collected by suction filtration and dried, to thereby obtain 117 g of (A-2). The molecular weight (Mw) and Mw/Mn of (A-2) were 23,000 and 1.74, respectively.

### (A-3) SA-AA copolymer (SA:AA = 80:20 (molar ratio))

SA (10.4 g, 32 mmol) and AA (0.58 g, 8 mmol) were dissolved in IPA (22 mL) and, to the resultant solution, AIBN (33 mg, 0.20 mmol) was further added. After degassing by bubbling with argon gas, the resultant solution was reacted at 60 °C for 18 hours. The resultant reaction mixture was cooled to room temperature under stirring, and deposited solids were collected by suction filtration and dried, to thereby obtain 8.18 g of (A-3). The molecular weight (Mw) and Mw/Mn of (A-3) were 24,400 and 1.74, respectively.

### (A-4) SA-AA copolymer (SA:AA = 70:30 (molar ratio))

Substantially the same procedure as in the preparation of (A-3) was repeated, except that SA (9.09 g, 28 mmol) and AA (0.87 g, 12 mmol) were dissolved in IPA (25mL), to thereby obtain 9.01 g of (A-4). The molecular weight (Mw) and Mw/Mn of (A-4) were 21,500 and 1.69, respectively.

### (A-5) DA-AA copolymer (DA:AA = 90:10 (molar ratio))

DA (D5075, manufactured by Tokyo Chemical Industry Co., Ltd., 10.3 g, 27.0 mmol) and AA (0.216 g, 3.0 mmol) were dissolved in IPA (25 g) and, to the resultant solution, AIBN (25 mg, 0.15 mmol) was further added. After degassing by bubbling with argon gas, the resultant solution was reacted at 55 °C for 24 hours. The resultant reaction mixture was cooled to room temperature, and deposited solids were collected by suction filtration and dried, to thereby obtain 10.5 g of (A-5).

### (A-6) SA-MA copolymer (SA:MA = 90:10 (molar ratio))

Substantially the same procedure as in the preparation of (A-4) was repeated, except that SA was used in an amount of 11.7 g (36 mmol) and MA (M0079, manufactured by Tokyo Chemical Industry Co., Ltd., 0.34 g, 4 mmol) was used in place of AA, to thereby obtain 9.11g of (A-6). The molecular weight (Mw) and Mw/Mn of (A-6) were 24,100 and 1.79, respectively.

### (A-7) Low molecular weight SA-AA copolymer (SA:AA = 90:10 (molar ratio))

SA (116.8 g, 360 mmol), AA(2.88 g, 40 mmol) and C12SH (126-02752, manufactured by FUJIFILM Wako Pure Chemical Corporation, 6.0 g, 30 mmol) were dissolved in toluene (120 g) and, after degassing by bubbling with nitrogen gas, the resultant solution was heated to 60 °C under stirring. To this solution was added, under nitrogen stream, a solution of V-601 (920 mg, 4.00 mmol) in toluene (5 g). The resultant mixture was heated to 90 °C and reacted at this temperature for 5 hours. The resultant reaction mixture was cooled to room temperature under stirring, and added to 1,500 mL of IPA. Deposited solids were collected by suction filtration and dried, to thereby obtain 109 g of (A-7). The molecular weight (Mw) and Mw/Mn of (A-7) were 7,900 and 1.18, respectively.

### (A-8) High molecular weight SA-AA copolymer (SA:AA = 90:10 (molar ratio))

SA (116.8 g, 360 mmol) and AA (2.88 g, 40 mmol) were dissolved in toluene (120 g) and, after degassing by bubbling with nitrogen gas, the resultant solution was heated to 80 °C under stirring. To this solution was added, under nitrogen stream, a solution of AIBN (330 mg, 2.00 mmol) in toluene (5 g). The resultant mixture was reacted at 80 °C for 8 hours. The resultant reaction mixture was cooled to room temperature under stirring, and added to 1,500 mL of IPA. Deposited solids were collected by suction filtration and dried, to thereby obtain 107 g of (A-8). The molecular weight (Mw) and Mw/Mn of (A-8) were 106,000 and 3.1, respectively.

Side-chain crystalline (meth)acrylate copolymer containing no repeating unit (ii) (Component (A')):
(A'-1) Low molecular weight SA-MAA copolymer (SA:MAA = 80:20 (molar ratio))
SA (9.38 g, 30 mmol) and MAA (A0145, manufactured by Tokyo Chemical Industry Co., Ltd., 0.62 g, 3.33 mmol) were dissolved in IPA (20 mL) and, to the resultant solution, V-601 (41.6 mg, 0.181 mmol) was further added. After degassing by bubbling with argon gas, the resultant solution was reacted at 60 °C for 18 hours. The resultant reaction mixture was cooled to room temperature under stirring, and deposited solids were collected by suction filtration and dried, to thereby obtain 9.5 g of (A'-1).

### Basic compound (Component (B))

- (B-1): DMOA (D1609, manufactured by Tokyo Chemical Industry Co., Ltd.)
- (B-2): 2MZ (2MZ-H, manufactured by Shikoku Chemicals Corporation)
- (B-3): C11Z (C11Z, manufactured by Shikoku Chemicals Corporation)
- (B-4): C17Z (C17Z, manufactured by Shikoku Chemicals Corporation)
- (B-5): octPy (327-98111, manufactured by FUJIFILM Wako Pure Chemical Corporation)

### Wax (Component (W))

(W-1) PEG-8000 (596-09755, manufactured by FUJIFILM Wako Pure Chemical Corporation, molecular weight: approximately 8,000, mp: 60 °C)

### [Preparation of Base-releasing Compositions]

(BRC-1) to (BRC-5), (BRC-10) to (BRC-13), (BRC'-1) to (BRC'-3)

In a glass bottle, Component (A) (or Component (A') or Component (W)) and Component (B) were charged in the proportion given in Table 1 (the proportions in the Table are given in weight %), together with a stirrer bar. The contents in the glass bottle were mixed in a molten state by stirring them with a hot stirrer at 80 °C. The stirring was continued for 1 hour after the contents became homogeneous, and the resultant mixture was allowed to cool. All of the resultant solid was taken out from the glass bottle and pulverized with a mortar, to thereby obtain a base-releasing composition.

### (BRC-6)

2 g of (A-2) and 28 mg of (B-2) were dissolved in 10 g of THF, and the resultant solution was stirred at room temperature for 1 hour using a magnetic stirrer. 20 g of IPA was added to the resultant solution. The resultant mixture including deposited solids was subj ected to centrifugation thereby precipitating the solids, and supernatant was removed. The resultant solids were dried under reduced pressure, to thereby obtain 1.62 g of (BRC-6).

### (BRC-7)

Substantially the same procedure as in the preparation of (BRC-6) was repeated, except that (A-2) was used in an amount of 1 g and 39 mg of (B-3) was used in place of (B-2), to thereby obtain 0.71 g of (BRC-7).

### (BRC-8)

Substantially the same procedure as in the preparation of (BRC-6) was repeated, except that (A-2) was used in an amount of 0.7 g and 38 mg of (B-4) was used in place of (B-2), to thereby obtain 0.54 g of (BRC-8).

### (BRC-9)

Substantially the same procedure as in the preparation of (BRC-7) was repeated, except that 33 mg of (B-5) was used in place of (B-3), to thereby obtain 0.70 g of (BRC-9).

In Table 1, also given are the amount (mmol) of basic groups per 1 g of the base-releasing composition and the molar ratio of basic groups in Component (B) relative to the repeating units (ii) in Component (A) for each composition. Each of the below-described (AB-1) and (AB-2) is not a base-releasing composition. However, the amount (mmol) of basic groups per 1 g of each of them is also described in Table 1 for convenience.

With respect to each of (BRC-1) to (BRC-5), (BRC-10) to (BRC-13) and (BRC'-1) to (BRC'-3), the amount of basic groups per 1 g of the base-releasing composition was calculated from the amounts of Component (A) (or Component (A') or Component (W)) and Component (B) used for the preparation of the composition. This calculation was carried out on the premise that no loss of Component (A) (or Component (A') or Component (W)) and Component (B) occurred during the preparation of the base-releasing composition.

With respect to each of (BRC-6) to (BRC-9), the amount of basic groups per 1 g of the composition was calculated from the ratio of peak areas in the ¹H-NMR spectrum (obtained in CDCl₃ by FT-NMR JNM-XCX400 (manufactured by JEOL Ltd.), using tetramethylsilane as an internal standard).

With respect to each of (BRC-1) to (BRC-13) and (BRC'-2), the molar ratio of basic groups in Component (B) relative to the repeating units (ii) in Component (A) was calculated by dividing the above-mentioned amount of basic groups per 1 g of the composition by the amount of the repeating units (ii) in Component (A) per 1 g of the composition.

The amount (mmol) of the repeating units (ii) in Component (A) per 1 g of the composition was calculated from the amount of each monomer (SA or DA, AA or MA) used for the preparation of Component (A) and the amounts of Component (A) and Component (B) used for the preparation of the base-releasing composition. This calculation was carried out on the premise that the amount ratio between the precursor of the repeating units (i) (SA or DA) and the precursor of the repeating units (ii) (AA or MA), the precursors used for the preparation of Component (A), is almost the same as the amount ratio between the repeating units (i) and the repeating units (ii) in Component (A), and that no loss of Component (A) and Component (B) occurred during the preparation of the base-releasing composition.

### [Table 1]

**Table 1**

| | | (BRC-1) | (BRC-2) | (BRC-3) | (BRC-4) | (BRC-5) | (BRC-6) | (BRC-7) | (BRC-8) | (BRC-9) | (BRC-10) | (BRC-11) | (BRC-12) | (BRC-13) | (BRC'-1) | (BRC'-2) | (BRC'-3) | (AB-1) | (AB-2) |
|---|---|---|---|---|---|---|---|---|---|---|---|---|---|---|---|---|---|---|---|
| Component (A) | (A-1) | 97.5 | | | | | | | | | | | | | | | | | |
| | (A-2) | | 90 | 97.5 | | | 98.6 | 96.3 | 94.8 | 99.2 | | | | | | 60 | | | |
| | (A-3) | | | | 95 | | | | | | | | | | | | | | |
| | (A-1) | | | | | 95 | | | | | | | | | | | | | |
| | (A-5) | | | | | | | | | | 95 | | | | | | | | |
| | (A-6) | | | | | | | | | | | 95 | | | | | | | |
| | (A-7) | | | | | | | | | | | | 95 | | | | | | |
| | (A-8) | | | | | | | | | | | | | 95 | | | | | |
| Component (A') | (A'-1) | | | | | | | | | | | | | | | | 95 | | |
| Component (W) | (W-1) | | | | | | | | | | | | | | 95 | | | | |
| Component (B) | (B-1) | 2.5 | 10 | 2.5 | 5 | 5 | | | | | 5 | 5 | 5 | 5 | 5 | 40 | 5 | | |
| | (B-2) | | | | | | 0.39 | | | | | | | | | | | | |
| | (B-3) | | | | | | | 1.25 | | | | | | | | | | | |
| | (B-4) | | | | | | | | 2.34 | | | | | | | | | | |
| | (B-5) | | | | | | | | | 0.8 | | | | | | | | | |
| Component (AB) | (AB-1) | | | | | | | | | | | | | | | | | 100 | |
| | (AB-2) | | | | | | | | | | | | | | | | | | 100 |
| Amount of basic groups^{a)} | | 0.08 | 0.34 | 0.08 | 0.17 | 0.17 | 0.10 | 0.11 | 0.15 | 0.04 | 0.17 | 0.17 | 0.17 | 0.17 | 0.17 | 1.34 | 0.17 | 2.14 | 0.33 |
| Basic groups / Acidic groups^{b)} | | 0.54 | 1.1 | 0.26 | 0.24 | 0.15 | 0.29 | 0.34 | 0.46 | 0.13 | 0.62 | 0.53 | 0.53 | 0.53 | - | 6.7 | - | - | - |

| | | | | | | | | | | | | | | | | | | | |
|---|---|---|---|---|---|---|---|---|---|---|---|---|---|---|---|---|---|---|---|
| a) Amount (mmol) of basic groups per 1 g of the composition (or (AB-1) or (AB-2)) b) Molar ratio of basic groups in Component (B) relative to repeating units (ii) in Component (A) | | | | | | | | | | | | | | | | | | | |

### Example P - 1

By the method described below using (A-2) to (A-8), reasonableness of the premise that the amount ratio between the precursor of the repeating units (i) and the precursor of the repeating units (ii), the precursors used for the preparation of Component (A), is almost the same as the amount ratio between the repeating units (i) and the repeating units (ii) in Component (A) was confirmed.

100 mg of Component (A) was dissolved in 2 mL of toluene and, to the resultant solution, a toluene solution of diazomethane prepared by the method described later was added. The amount of the toluene solution of diazomethane was sufficient for the mixture obtained by adding this solution to the above-mentioned solution of Component (A) to become yellow by excess diazomethane. The resultant mixture was reacted overnight at room temperature in a fume hood. After completion of the reaction, methanol was added to the resultant reaction mixture. Deposited solids were collected by filtration, washed with methanol and dried, to thereby obtain methylated Component (A) (methylated product). In the methylated product, virtually all of the repeating units (ii) (exactly, free carboxyl groups contained therein) are methylated.

The amount ratio between the repeating units (i) and the methylated repeating units (ii) in the methylated product was calculated from the ratio of peak areas in the ¹H-NMR spectrum (obtained in CDCl₃ by Lambda 400 MHz (manufactured by JEOL Ltd.), using tetramethylsilane as an internal standard) of the methylated product. Results are given in Table 2 below.

### Preparation of toluene solution of diazomethane

In a vial bottle made of polypropylene (PV-7, manufactured by Maruemu Corporation), an aqueous solution of potassium hydroxide (approximately 35 mass %, 10 mL) and 10 mL of toluene were charged. To the layer of the aqueous solution of potassium hydroxide, 10 % ethanol solution of p-toluenesulfonyl-N-methyl-nitrosoamide (CAS# 80-11-5), which had been separately prepared, was added portionwise so that generated diazomethane was absorbed by and dissolved into the toluene layer, to thereby prepare a toluene solution of diazomethane. All of these operations were carried out in a fume hood using plastic apparatuses.

### [Table 2]

**Table 2**

| | Amount ratio between monomers^{a)} | Amount ratio between repeating units^{b)} |
|---|---|---|
| A-2 | SA/AA=90:10 | 91 : 9 |
| A-3 | SA/AA=80:20 | 83 : 17 |
| A-4 | SA/AA=70:30 | 75 : 25 |
| A-5 | DA/AA=90:10 | 91 : 9 |
| A-6 | SA/MA=90:10 | 87 : 13 |
| A-7 | SA/AA=90:10 | 89 : 11 |
| A-8 | SA/AA=90:10 | 90 : 10 |

| | | |
|---|---|---|
| a) Amount ratio between the precursor of repeating units (i) and the precursor of repeating units (ii), the precursors used for the preparation of Component (A) b) Amount ratio between repeating units (i) and methylated repeating units (ii) in methylated Component (A) (repeating units (i) : repeating units (ii), calculated from the ratio of peak areas in the ¹H-NMR spectrum) | | |

### Example P-2

With respect to each of the above-mentioned (A-2), (BRC-8) and (BRC-9), the melting point was determined by subjecting it to DSC using differential scanning calorimeter DSC 204 F1 Phoenix (manufactured by NETZSCH Japan K.K.) at the rate of temperature increase of 10 °C/minute. Results are given in Table 3. These results show that the melting point of each of (A-2), (BRC-8) and (BRC-9) was approximately 50 °C.

### [Table 3]

**Table 3**

| | Peak temperature (°C) | Half width of peak (°C) | Quantity of heat of fusion (J/g) |
|---|---|---|---|
| A-2 | 55.0 | 2.8 | 116.6 |
| BRC-8 | 50.4 | 3.5 | 102.4 |
| BRC-9 | 50.8 | 3.0 | 102.1 |

### Example P-3

A test for confirmation of release of Component (B) from the base-releasing composition of the present invention under predetermined conditions was carried out as follows. In each procedure below, the room temperature was 25 °C.

In each of 2 microtubes provided, 25 mg of (BRC-6) and 1,000 mg of purified water were charged and the contents were subjected to vigorous shaking at room temperature. Each of the resultant mixtures was used as a sample.

One of these samples was filtered to remove solids. pH of the filtrate measured at room temperature was 6.7. Another sample was heated in a water bath set at 50 °C until (BRC-6) melted, subj ected to vigorous shaking again and allowed to cool to room temperature. The resultant mixture was filtered to remove solids. pH of the filtrate measured at room temperature was 9.4. Each of these pH measurements was carried out using a pH meter (LAQUA twin AS-712, manufactured by HORIBA, Ltd., subjected to 2-point calibration using pH standard solutions of pH 7 and pH 4 prior to use).

Almost neutral filtrate from the former sample shows that substantially no included (B-2) in (BRC-6) was released since the temperature was not changed from room temperature. On the other hand, it can be understood that in the latter sample, as a result of melting of (BRC-6) caused by heating to 50 °C, included (B-2) in (BRC-6) was at least partially released from that and dissolved into water around it.

### [Preparation of Curable Resin Compositions]

The raw materials for the curable resin compositions used in the following Examples and Comparative Examples, except for the base-releasing compositions, are as follows.

### 2-Methylene-1,3-dicarbonyl compounds:

DHMM (manufactured by Sirrus Inc., Chemilian^{™} L3000 XP)
DCHMM (manufactured by Sirrus Inc., Chemilian^{™} H4000 XP)

The specific structures for the 2-methylene-1,3-dicarbonyl compounds listed above are shown by the chemical formulae in Table 4 below.

### [Table 4]

**Table 4**

| | | |
|---|---|---|
| DHMM | Dihexyl methylene malonate | 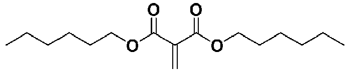 |
| DCHMM | Dicyclohexyl methylene malonate | 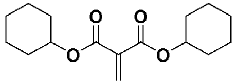 |

Side-chain crystalline (meth)acrylate copolymers having basic groups (Component (AB)):

### (AB-1) SA-DMAEA copolymer (SA:DMAEA = 50:50 (molar ratio))

SA (2.50 g, 7.70 mmol) and DMAEA (A1235, manufactured by Tokyo Chemical Industry Co., Ltd., 1.10 g, 7.70 mmol) were dissolved in toluene (6 mL) and further, to the resultant solution, C12SH (40 mg, 0.174 mmol) and V-601 (53 mg, 0.023 mmol) were added in this order. After degassing by bubbling with nitrogen gas, the resultant solution was reacted at 60 °C for 15 hours. The resultant reaction mixture was concentrated under reduced pressure with a rotary evaporator. Ethanol was added to the resultant concentrate. Deposited solids were collected by suction filtration and dried under reduced pressure, to thereby obtain 2.20 g of (AB-1).

### (AB-2) SA-DMAEA copolymer (SA:DMAEA = 90:10 (molar ratio))

SA (5.00 g, 15.4 mmol) and DMAEA (244 mg, 1.7 mmol) were dissolved in toluene (10 mL) and further, to the resultant solution, V-601 (20 mg, 0.088 mmol) was added. After degassing by bubbling with argon gas, the resultant solution was reacted at 66 °C for 17 hours. The resultant reaction mixture was allowed to cool to room temperature. IPA was added under stirring. Deposited solids were collected by suction filtration and dried, to thereby obtain 4.48 g of (AB-2).

With respect to each of (AB-1) and (AB-2), the amount of the basic groups per 1 g of each of them was calculated from the amount of each monomer used for the preparation of each of them. This calculation was carried out on the premise that the amount ratio between SA and DMAEA used for the preparation of each of the copolymers is almost the same as the amount ratio between the repeating units derived from SA and the repeating units derived from DMAEA in each of the copolymers. Each of (AB-1) and (AB-2) contains no acidic group.

### [Examples 1 to 16 and Comparative Examples 1 to 10]

The 2-methylene-1,3-dicarbonyl compound and the base-releasing composition (or Component (AB)) were charged into a mortar in accordance with the amounts given in Tables 5-1 and 5-2 (the amounts in the Tables are given in part(s) by weight) and fully stirred with a pestle, to thereby obtain a curable resin composition for evaluation.

With respect to the obtained curable resin compositions, polymerizability on heating and pot life were evaluated as follows. Results are given in Tables 5-1 and 5-2 below.

### [Evaluation of Polymerizability on Heating of Curable Resin Compositions]

The curable resin composition (approximately 500 mg) was charged into a microtube (1.5 mL) and heated for 1 hour in a drier set at the temperature given in Tables 5-1 and 5-2. After completion of the heating, the composition was taken out from the drier and allowed to stand still at room temperature (20 to 25 °C). After 10 and 60 minutes from the point of time of taking out the composition from the drier, the composition was observed for the presence or absence of its flow.

With respect to the composition which cured after less than 10 minutes from the point of time of taking out the composition from the drier, the polymerizability on heating was evaluated as "⊚".

With respect to the composition which cured not after 10 minutes but after less than 60 minutes from the point of time of taking out the composition from the drier, the polymerizability on heating was evaluated as "△".

With respect to the composition which did not cure (was still in a liquid form) after 60 minutes from the point of time of taking out the composition from the drier, the polymerizability on heating was evaluated as "×".

With respect to the composition which cured prior to the heating in the drier, the polymerizability on heating was not evaluated (labeled as "-" in Table 5-2).

"Cured" state means a state in which no flow of the composition was observed even when the microtube was inclined or shaken.

### [Evaluation of Pot Life of Curable Resin Compositions]

The curable resin composition (approximately 500 mg) was charged into a microtube (1.5 mL) equipped with a thermocouple and, while monitoring the temperature of the microtube, allowed to stand still at room temperature (20 to 25 °C). The period of time from the point of time of the beginning of being allowed to stand still until exotherm due to polymerization reaction was observed was regarded as the pot life (unit: hour(s)).

### [Table 5-1]

**Table 5-1**

| | | Ex. 1 | Ex. 2 | Ex. 3 | Ex. 4 | Ex. 5 | Ex. 6 | Ex. 7 | Ex. 8 | Ex. 9 | Ex. 10 | Ex. 11 | Ex. 12 | Ex. 13 | Ex. 14 | Ex. 15 | Ex. 16 |
|---|---|---|---|---|---|---|---|---|---|---|---|---|---|---|---|---|---|
| Base-releasing composition | BRC-1 | 0.5 | | | | | | | | | | | | | | | |
| | BRC-2 | | 0.1 | | | | | | | | | | | | | | |
| | BRC-3 | | | 0.5 | | | | | | | | | | | | | |
| | BRC-4 | | | | 0.5 | | | | | | | | | | | | |
| | BRC-5 | | | | | 0.5 | | | | | | | | | | | |
| | BRC-6 | | | | | | 0.5 | | | | | | | | | | |
| | BRC-7 | | | | | | | 0.5 | | | | | | | | | |
| | BRC-8 | | | | | | | | 0.5 | | | | | | | 1 | |
| | BRC-9 | | | | | | | | | 0.5 | | | | | 1 | | 2 |
| | BRC-10 | | | | | | | | | | 0.5 | | | | | | |
| | BRC-11 | | | | | | | | | | | 0.5 | | | | | |
| | BRC-12 | | | | | | | | | | | | 0.5 | | | | |
| | BRC-13 | | | | | | | | | | | | | 0.5 | | | |
| | BRC'-1 | | | | | | | | | | | | | | | | |
| | BRC'-2 | | | | | | | | | | | | | | | | |
| | BRC'-3 | | | | | | | | | | | | | | | | |
| Component (AB) | AB-1 | | | | | | | | | | | | | | | | |
| | AB-2 | | | | | | | | | | | | | | | | |
| Methylene malonate | DHMM | 100 | 100 | 100 | 100 | 100 | 100 | 100 | 100 | 100 | 100 | 100 | 100 | 100 | | 100 | 100 |
| | DCHMM | | | | | | | | | | | | | | 100 | | |
| Temperature (°C) | | 70 | 70 | 70 | 70 | 70 | 70 | 70 | 70 | 70 | 70 | 70 | 70 | 70 | 70 | 50 | 50 |
| Curability upon heating | | ⊚ | ⊚ | ⊚ | ⊚ | ⊚ | ⊚ | ⊚ | ⊚ | ⊚ | ⊚ | ⊚ | ⊚ | ⊚ | ⊚ | ⊚ | ⊚ |
| Pot life (h) | | 8.0 | 5.8 | 20 | 17 | 5.0 | 6.5 | 13 | 13 | 35 | 8.0 | 12 | 16 | 16 | 18 | 8.0 | 4.5 |

### [Table 5-2]

**Table 5-2**

| | | Com. Ex. 1 | Com. Ex. 2 | Com. Ex. 3 | Com. Ex. 4 | Com. Ex. 5 | Com. Ex. 6 | Com. Ex. 7 | Com. Ex. 8 | Com. Ex. 9 | Com. Ex. 10 | Com. Ex. 11 |
|---|---|---|---|---|---|---|---|---|---|---|---|---|
| Base- releasing composition | BRC-1 | | | | | | | | | | | |
| | BRC-2 | | | | | | | | | | | |
| | BRC-3 | | | | | | | | | | | |
| | BRC-4 | | | | | | | | | | | |
| | BRC-5 | | | | | | | | | | | |
| | BRC-6 | | | | | | | | | | | |
| | BRC-7 | | | | | | | | | | | |
| | BRC-8 | | | | | | | | | | | |
| | BRC-9 | | | | | | | | | | | |
| | BRC-10 | | | | | | | | | | | |
| | BRC-11 | | | | | | | | | | | |
| | BRC-12 | | | | | | | | | | | |
| | BRC-13 | | | | | | | | | | | |
| | BRC'-1 | 0.5 | | | | | | | | | | |
| | BRC'-2 | | | | | | | | | | 0.5 | |
| | BRC'-3 | | | | | | | | | | | 0.5 |
| Component (AB) | AB-1 | | 0.5 | 0.1 | 0.05 | 0.025 | | | | | | |
| | AB-2 | | | | | | 0.265 | 0.5 | 1 | 2 | | |
| Methylene malonate | DHMM | 100 | 100 | 100 | 100 | 100 | 100 | 100 | 100 | 100 | 100 | 100 |
| | DCHMM | | | | | | | | | | | |
| Temperature (°C) | | 70 | 70 | 70 | 70 | 70 | 70 | 70 | 70 | 70 | 70 | 70 |
| Curability upon heating | | ⊚ | ⊚ | ⊚ | ∧ | x | x | x | △ | △ | - | ⊚ |
| Pot life (h) | | 0.23 | 0.45 | 2.5 | 6.5 | 19 | 43 | 18 | 13 | 9.0 | 0.08 | 2.8 |

### (Discussion of results)

As apparent from Examples 1 to 16, the curable resin composition comprising the base-releasing composition of the present invention exhibited excellent polymerizability on heating as well as satisfactorily long pot life at room temperature. This fact shows that in the base-releasing composition of the present invention, release of Component (B) is satisfactorily suppressed at room temperature but rapid release of Component (B) is achieved by heating to a predetermined temperature.

On the other hand, Comparative Examples 1 to 11 show that excellent polymerizability under predetermined conditions and /or satisfactorily long pot life at room temperature of the curable resin composition cannot be achieved when an initiator not corresponding to Component (A) is used.

Especially, comparison of Examples 1 and 3 to 13 with Comparative Example 7 clearly shows that a curable resin composition comprising Component (AB) (corresponding to Component (A) covalently bonded to Component (B)) exhibits lower polymerizability as compared to that of the curable resin composition of the present invention, even when the amount of Component (AB) is almost the same as the amount of the base-releasing composition in the curable resin composition of the present invention (in this case, the amount of the basic groups in the curable resin composition comprising Component (AB) is larger than that in the curable resin composition comprising the base-releasing composition). This is presumed to be mainly because Component (AB) as an initiator is difficult to be diffused throughout the polymerization system. As described above, Component (AB) comprises a moiety corresponding to Component (B) in a state being covalently bonded to a moiety corresponding to Component (A). Therefore, Component (AB) is a high molecular weight basic compound as a whole, and its diffusion rate in the polymerization system is low. Further, because of such a chemical structure of Component (AB), Component (B) is not released from Component (AB) even when it is heated and, among the basic groups in Component (AB), virtually only those present on the surface of the phase of Component (AB) in the polymerization system may contribute to initiation of polymerization of 2-methylene-1,3-dicarbonyl compound. In addition, Component (AB), which is a high molecular weight compound, exhibits weak action as an initiator for the 2-methylene-1,3-dicarbonyl compound, because of steric hindrance and the like. It is conceivable that these facts are reflected in the above-mentioned low polymerizability.

The polymerizability is improved when the amount of Component (AB) in the curable resin composition is increased (Comparative Examples 8 to 9). However, in a certain use, this is unuseful because of white turbidity (Comparative Example 9).

The polymerizability is improved also when Component (AB) with increased amount of basic groups and lowered molecular weight for improved diffusibility is used. However, the pot life is disadvantageously shortened (Comparative Example 2). The pot life is extended when the amount of Component (AB) is decreased. However, the polymerizability is disadvantageously lowered (Comparative Examples 3 to 5). Further, because of large change in polymerizability relative to the change in the content of such Component (AB) in the curable resin composition, this Component (AB) has poor usefulness (Comparative Examples 4 to 5).

In a curable resin composition using, in place of Component (A), a wax (Component (W)) used in related art (Comparative Example 1), release of Component (B) is not satisfactorily suppressed at room temperature and the pot life is short. Similar tendency is found in a curable resin composition using, in place of Component (A), a side-chain crystalline (meth)acrylate copolymer containing no repeating unit (ii) (carboxyl groups in repeating units (ii) are methylated to form methoxycarbonyl groups) (Comparative Example 11).

### Industrial applicability

In the base-releasing composition of the present invention, release of the basic compound is satisfactorily suppressed at room temperature, and the basic compound is rapidly released under predetermined conditions. A curable resin composition using such a base-releasing composition can be stored for a long time at room temperature and rapidly cures under predetermined conditions. Therefore, the base-releasing composition of the present invention is extremely useful in the production of electronic components, especially when it is used in a curable resin composition in combination with a 2-methylene-1,3-dicarbonyl compound.

### REFERENCE SIGNS LIST

- 10: Camera module
- 12: Lens
- 14: Voice coil motor
- 16: Lens unit
- 18: Support
- 20: Cutting filter
- 22: Image sensor
- 24: Printed circuit board
- 30, 32, 34: Adhesive

The disclosure of Japanese Patent Application No. 2020-181351 (filing date: October 29, 2020) is incorporated herein by reference in their entirety.

All publications, patent applications, and technical standards mentioned in the present specification are incorporated herein by reference to the same extent as if such individual publication, patent application, and technical standard were specifically and individually indicated to be incorporated by reference.

## Claims

1. A base-releasing composition comprising the following Components (A) and (B):
(A) a side-chain crystalline (meth)acrylate copolymer comprising (i) repeating units each derived from an ester of a C₈-C₃₂ saturated, linear primary alcohol with acrylic acid or methacrylic acid and (ii) repeating units each derived from acrylic acid or methacrylic acid; and
(B) a basic compound,
wherein the amount of basic groups in the (B) basic compound is 0.01 to 1.00 mmol per 1 g of the base-releasing composition, and
wherein at least a portion of the (B) basic compound is included in the (A) side-chain crystalline (meth)acrylate copolymer.

2. The base-releasing composition according to claim 1, wherein the molar ratio of basic groups in the (B) basic compound relative to the repeating units (ii) in the (A) side-chain crystalline (meth)acrylate copolymer is 0.05 to 2.0.

3. The base-releasing composition according to claim 1 or 2, wherein the (B) basic compound comprises a basic compound having a linear hydrocarbon group with 8 or more carbon atoms.

4. The base-releasing composition according to any one of claims 1 to 3, wherein, when the base-releasing composition is heated to a temperature of 50 °C or higher in a medium, the (B) basic compound is released into the medium.

5. A curable resin composition comprising the base-releasing composition according to any one of claims 1 to 4 and a 2-methylene-1,3-dicarbonyl compound,
wherein the 2-methylene-1,3-dicarbonyl compound has at least one structural unit represented by formula (I) below.

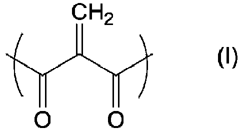

6. A one-part adhesive comprising the curable resin composition of claim 5.

7. The one-part adhesive according to claim 6, for electronic components.

8. A cured product which can be obtained by curing the one-part adhesive of claim 6 or 7.

9. A semiconductor device comprising the cured product of claim 8.
